**Europäisches Patentamt**

**European Patent Office**

**Office européen des brevets**

(11) Veröffentlichungsnummer: **0 131 575**

**B1**

# (12) EUROPÄISCHE PATENTSCHRIFT

(45) Veröffentlichungstag der Patentschrift:
02.09.87

(21) Anmeldenummer: **83902527.7**

(22) Anmeldetag: **03.08.83**

(86) Internationale Anmeldenummer:
**PCT/EP 83/00205**

(87) Internationale Veröffentlichungsnummer:
**WO 84/00826 (01.03.84 Gazette 84/06)**

(51) Int. Cl.⁴: **G 03 F 7/26, G 03 F 7/08**

(54) **WÄSSRIG-ALKALISCHE LÖSUNG UND VERFAHREN ZUM ENTWICKELN VON POSITIV-ARBEITENDEN REPRODUKTIONSSCHICHTEN.**

(30) Priorität: **13.08.82 DE 3230171**

(43) Veröffentlichungstag der Anmeldung:
**23.01.85 Patentblatt 85/4**

(45) Bekanntmachung des Hinweises auf die Patenterteilung:
**02.09.87 Patentblatt 87/36**

(84) Benannte Vertragsstaaten:
**AT BE CH DE FR GB IT LI LU NL SE**

(56) Entgegenhaltungen:
**EP-A-0 023 758**
**EP-A-0 056 092**
**FR-A-2 185 631**
**GB-A-1 591 988**

**Japanese Patents Report, Vol. 78, No. 8, Section G,
16-22 February 1978, 24 March 1978, Derwent
Publications London (GB) JP, B, 78004423 (SAN EI
CHEM. IND. K.K.) 17-02-1978**
**IBM Technical Disclosure Bulletin, Vol. 13, No. 7,
December 1970, New York (US), M.J. Grieco et al.:
"Photoresist developer compounds", pages 2009**
**IBM Technical Disclosure Bulletin, Vol. 16, No. 2,
July 1973, New York (US), J.J. Difazio et al.:
"Positive photoresist development process", see
page 426**

(73) Patentinhaber: **HOECHST AKTIENGESELLSCHAFT,
Postfach 80 03 20, D-6230 Frankfurt am Main 80
(DE)**

(72) Erfinder: **SIMON, Ulrich, Fontanestrasse 41, D-6500
Main- Lerchenberg (DE)**
Erfinder: **BEUTEL, Rainer, Wiesenhain 8, D-6200
Wiesbaden- Breckenheim (DE)**

## Beschreibung

Die Erfindung betrifft eine wäßrig-alkalische Entwicklerlösung für strahlungsempfindliche, positiv-arbeitende Reproduktionsschichten auf der Basis von Silikaten und einem Hydroxid und ein Verfahren zum Entwickeln der genannten Schichten.

Strahlungs(licht)empfindliche Reproduktionsschichten werden beispielsweise bei der Herstellung von Offsetdruckformen oder von Photoresists (beides im weiteren Kopiermaterialien genannt) verwendet, d. h. sie werden im allgemeinen vom Verbraucher oder vom industriellen Hersteller auf einen Schichtträger aufgebracht. Als Schichtträger in diesen Kopiermaterialien werden Metalle wie Zink, Magnesium, Chrom, Kupfer, Messing, Stahl, Silicium, Aluminium oder Kombinationen dieser Metalle, Kunststoffolien, Papier oder ähnliche Materialien eingesetzt. Diese Schichtträger können ohne eine modifizierende Vorbehandlung, bevorzugt aber nach Durchführung einer Oberflächenmodifizierung wie einer mechanischen, chemischen und/oder elektrochemischen Aufrauhung, einer Oxidation und/oder einer Behandlung mit Hydrophilierungsmitteln (z. B. bei Trägern für Offsetdruckplatten), mit der strahlungsempfindlichen Reproduktionsschicht beschichtet werden. Die üblichen Reproduktionsschichten enthalten neben mindestens einer strahlungsempfindlichen Verbindung meist noch ein organisches Bindemittel (Harze o. ä.) und gegebenenfalls auch noch Weichmacher, Pigmente, Farbstoffe, Netzmittel, Sensibilisatoren, Haftvermittler, Indikatoren und andere übliche Hilfsmittel. Die Reproduktionsschichten werden nach ihrer Belichtung entwickelt, um aus ihnen ein Bild zu erzeugen, beispielsweise wird so eine Druckform oder ein Photoresist erhalten.

Ein Entwickler für positiv-arbeitende Reproduktionsschichten muß die von elektromagnetischer Strahlung getroffenen Schichtteile (die späteren Nichtbildstellen) aus der belichteten Schicht herauslösen können, ohne dabei die von der Strahlung nicht getroffenen Teile (die späteren Bildstellen) der Schicht wesentlich zu beeinflussen. In der beispielhaft zu nennenden DE-PS 12 00 133 (= US-PS 3 110 596) werden als geeignete Entwickler beispielsweise aufgeführt: alkalisch-wäßrige Lösungen von Phosphaten, Silikaten, Fluorosilikaten, Stannaten, Fluoroboraten oder Fluorotitanaten, die gegebenenfalls auch noch wasserlösliche Hydrokolloide oder organische Lösemittel enthalten können.

Um diese wäßrig-alkalischen Entwicklerlösungen zu verbessern, wurden im Stand der Technik auch bereits verschiedenste Alternativen oder Modifizierungen beschrieben:

In der DE-OS 28 34 958 (= ZA-PS 79/4131) wird ein Verfahren zum Entwickeln von positiv-arbeitenden lichtempfindlichen Schichten auf der Basis von o-Naphthochinondiaziden und alkalilöslichen Harzen beschrieben, dei dem die belichteten Schichtbereiche mit einer wäßrig-alkalischen Entwicklerlösung ausgewaschen werden, die a) eine alkalisch reagierende Verbindung wie Wasserglas, Na-metasilikat, $Na_3PO_4$, $K_3PO_4$, $Na_2HPO_4$, $K_2HPO_4$, NaOH, KOH, Diethylamin, Ethanolamin oder Trietholamin, und b) ein Salz, Oxid oder Hydroxid eines Elements der II. oder III. Hauptgruppe oder der III. Nebengruppe des Periodensystems der Elemente wie des Calciums, Strontiums oder Bariums enthält.

Aus der GB-PS 1 591 988 ist ein Entwicklungsverfahren für positiv-arbeitende lichtempfindliche Schichten auf der Basis von o-Naphthochinondiazidestern und alkalilöslichen Harzen bekannt, bei dem der Entwickler a) 75 bis 99,5 Vol.-% einer wäßrig-alkalischen Lösung wie einer wäßrigalkalischen Na-metasilikat- oder $Na_3PO_4$-Lösung und b) 0,5 bis 25 Vol.-% eines organischen Lösemittels wie Alkanole oder Alkandiole (oder deren Monoether) enthält. Als weitere Komponenten werden auch NaOH, Na-benzoat, Dimethylformamid, Polyethylenglykol, $Na_2HPO_4$ und Tetranatriumethylendiamintetraacetat genannt.

M. J. Grieco et al. in IBM-Technical Disclosure Bulletin, Vol. 13, Nr. 7, 12/1970, S. 2009, nennen wäßrig- oder alkoholisch-alkalische Lösungen (ohne Gehalt an $Na+$-Ionen) mit einem pH-Wert im Bereich von 9 bis 13 und einem Gehalt von 5 bis 25 % an Tetramethyl-ammoniumhydroxid als geeignet zur Entwicklung von positiv-arbeitenden Photoresists.

Bei der Herstellung von Halbleiterschichten nach der JP-OS 155 280/75 (veröffentlicht am 22. Dezember 1975) werden positiv-arbeitende Photoresists auf der Basis von o-Naphthochinondiaziden und Novolakharzen mit einer wäßrigen, 1 bis 4 Gew.-% an Tetramethyl-ammoniumhydroxid enthaltenden Lösung entwickelt.

In der JP-AS 4423/78 (bekanntgemacht am 17. Februar 1978) werden wäßrige oder alkoholische Lösungen von Tetraalkylammoniumhydroxid (Alkyl von $C_1$ bis $C_7$) als geeignet zur Entwicklung von positiv-arbeitenden Photoresists auf der Basis von o-Naphthochinondiaziden und Novolakharzen beschrieben. Auch Tetrahydroxyethyl-ammoniumhydroxid wird als Entwicklerkomponente genannt, aber als weniger geeignet bezeichnet.

Aus der DE-OS 23 12 499 (= GB-PS 1 367 830) sind positivarbeitende Photoresists auf der Basis von Diazochinon-Siloxanen und alkalilöslichen Bindemitteln bekannt, die mit einer wäßrigen Lösung entwickelt werden, die 1,7 Gew.-% Tetramethyl-ammoniumhydroxid und ein anionisches Tensid enthalten.

Der Entwickler für positiv-arbeitende, Chinondiazide ent haltende lichtempfindliche Schichten auf den Gebieten Photoresists und Druckplatten gemäß der US-PS 4 141 733 enthält in wäßriger Lösung 1 bis 30 Gew.-% Methyl-trihydroxyethyl-ammoniumhydroxid. In Vergleichsbeispielen werden auch Tetramethyl-, Tetraethyl-, Benzyl-methyl-dihydroxyethyl- und Benzyl-hydroxyethyl-dimethyl-ammoniumhydroxid eingesetzt. Quaternäre Ammoniumhydroxide, die mindestens eine Hydroxyalkylgruppe tragen, können nach der EP-A- 0 023 758 (= US-PS 4 294 911) in Entwicklern durch Zugabe von Sulfiten, Hydrosulfiten oder Pyrosulfiten (Disulfite, Metasulfite) stabilisiert werden.

Die bekannten Entwickler weisen jedoch noch einige Nachteile auf, beispielsweise greifen sie oftmals die Aluminiumoxidschicht der Trägermaterialien von Druckplatten an, oder sie bewirken eine zu flache Gradation (zu wenig steile Gradation) in den Bildstellen.

Aufgabe der vorliegenden Erfindung ist es deshalb, einen Entwickler für positiv-arbeitende, strahlungsempfindliche Reproduktionsschichten vorzuschlagen, aus dessen Anwendung eine Druckform ohne nennenswerten Angriff am Trägermaterial dieser Schichten resultiert, die in den Bildstellen eine relativ steile Gradation bei gutem Auflösevermögen zeigt.

Die Erfindung geht aus von der bekannten wäßrig-alkalischen Entwicklerlösung für strahlungsempfindliche, positiv-arbeitende Reproduktionsschichten auf der Basis von Silikaten und einem Hydroxid. Die erfindungsgemäße Entwicklerlösung ist dann dadurch gekennzeichnet, daß sie 0,001 bis 1,0 Gewichtsprozent an Tetraalkylammoniumhydroxid, dessen Alkylsubstituenten gleich oder verschieden sind und 1 bis 6 C-Atome enthalten, oder ein Salz davon und 5 bis 15 Gewichtsprozent an Alkalisilikat enthält. Unter den Begriff "quaternäre Ammoniumbase" sollen nicht nur bereits außerhalb der wäßrig-alkalischen Entwicklerlösung als Basen vorliegende Verbindungen fallen, sondern auch solche - wie beispielsweise quaternäre Ammoniumsalze, die in der Entwicklerlösung dissoziieren -, die quaternäre Ammoniumionen liefern, die in der wäßrig-alkalischen Lösung im Ionengleichgewicht vorliegen. Zu den Tetraalkylammoniumhydroxiden, deren Alkylsubstituenten gleich oder verschieden sind und ein bis 6 C-Atome enthalten, zählen beispielsweise:

Tetramethyl-ammoniumhydroxid (TMAH)
Tetraethyl-ammoniumhydroxid (TEAH)
Tetrapropyl-ammoniumhydroxid (TPAH)
Tetrabutyl-ammoniumhydroxid (TBAH)
Tributyl-methyl-ammoniumhydroxid (TBMAH)

Die wäßrig-alkalische Entwicklerlösung enthält neben dem Lösemittel Wasser in der Hauptsache ein Silikat, insbesondere ein Alkalisilikat wie Natriummetasilikat in einer Menge von 5 bis 15 Gew.-%, insbesondere von 6 bis 13 Gew.-%. Bei relativ niedrigen Silikatkonzentrationen kann es - abhängig von der in der Lösung vorhandenen Menge der übrigen Komponenten - nach der Entwicklung zum Auftreten von "Ton" kommen. Dieser Effekt kann jedoch durch Abänderung der Konzentration oder Art der anderen Komponenten verhindret werden.

Die quaternäre Ammoniumbase ist in dieser wäßrig-alkalischen Entwicklerlösung vorzugeweise in einem Anteil von 0,002 bis 0,1 Gew.-%, vorhanden. Bevorzugte Entwicklerlösungen enthalten zusätzlich noch ein Salz einer organischen, gegebenenfalls substituierten aromatischen Monocarbonsäure, insbesondere ein Alkalisalz von gegebenenfalls substituierter Benzoesäure wie Natriumbenzoat oder -salicylat, in einer Menge von 0,01 bis 10,0 Gew.-%, insbesondere von 0,1 bis 5,0 Gew.-%. Neben den bereits genannten Komponenten kann die erfindungsgemäße Entwicklerlösung gegebenenfalls auch noch übliche Zusätze wie ionogene oder nichtionogene Tenside, Antischaummittel, die Viskosität beeinflussende Mittel, Konservierungsmittel, Komplexbildner oder - maximal bis zu 5 Gew.-% - mit Wasser mischbare organische Lösemittel enthalten.

Eine weitere Lösung der gestellten Aufgabe ist auch ein Verfahren zum Entwickeln von belichteten, strahlungsempfindlichen, positiv-arbeitenden Reproduktionsschichten auf einem Trägermaterial auf der Basis von Aluminium, bei dem die belichteten Schichtbereiche mit der erfindungsgemäßen Entwicklerlösung ausgewaschen werden.

Die zu entwickelnde Reproduktionsschicht liegt insbesondere als Teil (strahlungsempfindliche Schicht) einer Offsetdruckplatte oder als auf ein Trägermaterial aufgebrachter Resist (Photoresistschicht) vor. Als Trägermaterial kommt bevorzugt Aluminium oder eine seiner Legierungen in Betracht. Die Träger können ohne eine spezielle modifizierende Vorbehandlung mit einer geeigneten Reproduktionsschicht versehen werden, bevorzugt wird diese Beschichtung jedoch erst nach einer Oberflächenmodifizierung wie einer mechanischen, chemischen und/oder elektrochemischen Aufrauhung, einer Oxidation und/oder einer Behandlung mit Hydrophilierungsmitteln (insbesondere bei Trägern für Offsetdruckplatten) durchgeführt.

Die in der Praxis sehr häufig anzutreffenden Aluminiumträgermaterialien für Druckplatten mit einem Gehalt von mehr als 98,5 Gew.-% Al und Anteilen an Si, Fe, Ti, Cu und Zn werden im allgemeinen vor Aufbringen der strahlungsempfindlichen Schicht noch mechanisch (z. B. durch Bürsten und/oder mit Schleifmittel-Behandlungen), chemisch (z. B. durch Ätzmittel) oder elektrochemisch (z. B. durch Wechselstrombehandlung in wäßrigen HCl- oder $HNO_3$-Lösungen) aufgerauht. Die mittlere Rauhtiefe $R_z$ der aufgerauhten Oberfläche liegt dabei im Bereich von etwa 1 bis 15 μm. Die Rauhtiefe wird nach DIN 4768 in der Fassung vom Oktober 1970 ermittelt, die Rauhtiefe $R_z$ ist dann das arithmetische Mittel aus den Einzelrauhtiefen fünf aneinandergrenzender Einzelmeßstrecken.

Nach dem bevorzugt angewendeten elektrochemischen Aufrauhverfahren schließt sich dann in einer weiteren, gegebenenfalls anzuwendenden Verfahrensstufe eine anodische Oxidation des Aluminiums an, um beispielsweise die Abriebs- und Haftungseigenschaften der Oberfläche des Trägermaterials zu verbessern. Zur anodischen Oxidation können die üblichen Elektrolyte wie $H_2SO_4$, $H_3PO_4$, $H_2C_2O_4$, Amidosulfonsäure, Sulfobernsteinsäure, Sulfosalicylsäure oder deren Mischungen eingesetzt werden. Es wird beispielsweise auf folgende Standardmethoden für den Einsatz von $H_2SO_4$ enthaltenden wäßrigen Elektrolyten für die anodische Oxidation von Aluminium hingewiesen (s. dazu z. B. M. Schenk, Werkstoff Aluminium und seine anodische Oxydation, Francke Verlag - Bern, 1948, Seite 760; Praktische Galvanotechnik, Eugen G. Leuze Verlag - Saulgau, 1970, Seiten 395 ff und Seiten 518/519; W. Hübner und C. T. Speiser, Die Praxis der anodischen Oxidation des Aluminiums, Aluminium Verlag - Düsseldorf, 1977, 3. Auflage, Seiten 137 ff):

- Das Gleichstrom-Schwefelsäure-Verfahren, bei dem in einem wäßrigen Elektrolyten aus üblicherweise ca. 230 g $H_2SO_4$ pro 1 l Lösung bei 10° bis 22°C und einer Stromdichte von 0,5 bis 2,5 $A/dm^2$ während 10 bis 60 min anodisch oxidiert wird. Die Schwefelsäurekonzentration in der wäßrigen Elektrolytlösung kann dabei auch bis auf 8 bis 10 Gew.-% $H_2SO_4$ (ca. 100 g $H_2SO_4/l$) verringert oder auch auf 30 Gew.-% (365 g $H_2SO_4/l$) und mehr erhöht werden.

- Die "Hartanodisierung" wird mit einem wäßrigen, $H_2SO_4$ enthaltenden Elektrolyten einer Konzentration von 166 g $H_2SO_4/l$ (oder ca. 230 g $H_2SO_4/l$) bei einer Betriebstemperatur von 0° bis 5°C, bei einer Stromdichte von 2 bis 3 A/dm2, einer steigenden Spannung von etwa 25 bis 30 V zu Beginn und etwa 40 bis 100 V gegen Ende der Behandlung und während 30 bis 200 min durchgeführt.

Neben den im vorhergehenden Absatz bereits genannten Verfahren zur anodischen Oxidation von Druckpaltten-Trägermaterialien können beispielsweise noch die folgenden Verfahren zum Einsatz kommen: die anodische Oxidation von Aluminium in einem wäßrigen $H_2SO_4$ enthaltenden Elektrolyten, dessen $Al^{3+}$-Ionengehalt auf Werte von mehr als 12 g/l eingestellt wird (nach der DE-OS 28 11 396 = US-PS 4 211 619), in einem wäßrigen, $H_2SO_4$ und $H_3PO_4$ enthaltenden Elektrolyten (nach der DE-OS 27 07 810 = US-PS 4 049 504) oder in einem wäßrigen, $H_2SO_4$, $H_3PO_4$ und $Al^{3+}$-Ionen enthaltenden Elektrolyten (nach der DE-OS 28 36 803 = US-PS 4 229 226). Zur anodischen Oxidation wird bevorzugt Gleichstrom verwendet, es kann jedoch auch Wechselstrom oder eine Kombination dieser Stromarten (z. B. Gleichstrom mit überlagertem Wechselstrom) eingesetzt werden. Die Schichtgewichte an Aluminiumoxid bewegen sich im allgemeinen im Bereich von 1 bis 10 g/m2, entsprechend einer Schichtdicke von etwa 0,3 bis 3,0 µm.

Der Stufe einer anodischen Oxidation des Druckplatten-Trägermaterials aus Aluminium können auch eine oder mehrere Nachbehandlungsstufen nachgestellt werden. Dabei wird unter Nachbehandeln insbesondere eine hydrophilierende chemische oder elektrochemische Behandlung der Aluminiumoxidschicht verstanden, beispielsweise eine Tauchbehandlung des Materials in einer wäßrigen Polyvinylphosphonsäure-Lösung nach der DE-PS 16 21 478 (= GB-PS 1 230 447), eine Tauchbehandlung in einer wäßrigen Alkalisilikat-Lösung nach der DE-AS 14 71 707 (= US-PS 3 181 461) oder eine elektrochemische Behandlung (Anodisierung) in einer wäßrigen Alkalisilikat-Lösung nach der DE-OS 25 32 769 (= US-PS 3 902 976). Diese Nachbehandlungsstufen dienen insbesondere dazu, die bereits für viele Anwendungsgebiete ausreichende Hydrophilie der Aluminiumoxidschicht noch zusätzlich zu steigern, wobei die übrigen bekannten Eigenschaften dieser Schicht mindestens erhalten bleiben.

Die erfindungsgemäße wäßrig-alkalische Entwicklerlösung ist grundsätzlich für alle positiv-arbeitenden Reproduktionsschichten geeignet, insbesondere jedoch für o-Chinondiazide, insbesondere o-Naphthochinondiazide wie Naphthochinon-(1,2)-diazid-(2)-sulfonsäureester oder -amide, die nieder- oder höhermolekular sein können, als strahlungsempfindliche Verbindung enthaltende Schichten. Diese Reproduktionsschichten enthalten neben mindestens einem dieser o-Chinondiazide alkalilösliche Harze, beispielsweise Phenolharze, Acryl- oder Methacrylsäuremischpolymerisate, Maleinsäuremischpolymerisate und andere zur Salzbildung befähigte Gruppen enthaltende Polymerisate; bevorzugt werden Phenolharze, insbesondere Novolake. Witere mögliche Schichtbestandteile sind u. a. kleine Mengen alkalilöslicher Harze, Farbstoffe, Weichmacher, Haftverbesserungsmittel oder Tenside, solche Reproduktionsschichten werden beispielsweise in den DE-PSen 854 890, 865 109, 879 203, 894 959, 938 233, 1 109 521, 1 144 705, 1 118 606, 1 120 273, 1 124 817 und 2 331 377, und den EP-OSen 0 021 428 und 0 055 814 beschrieben.

Durch die Erfindung wird erreicht, daß die Bildstellen nach der Entwicklung eine verhältnismäßig steile Gradation und ein gutes Auflösevermögen zeigen. Es tritt dabei eine gute Differenzierung der Bildstellen von den Nichtbildstellen auf, d. h. die aufzulösenden Schichtbestandteile können rückstandslos entfernt werden, ohne daß eine Unterwanderung der Bildstellen stattfindet. Trotz der guten Entwicklungsleistung greift die erfindungsgemäße Entwicklerlösung die Trägermaterialien der Reproduktionsschicht, insbesondere Aluminiumoxidschichten nicht an, solange in der Praxis übliche Entwicklungszeiten angewandt werden. Verglichen mit Entwicklerlösungen aus dem Stand der Technik können auch höhere Konzentrationen an Silikaten angewandt werden, ohne daß es zu einem gleichwertig starken Oxidschichtangriff kommt.

In den nachfolgenden Beispielen beziehen sich Prozentangaben auf das Gewicht, und Gew.-Teile stehen zu Vol.-Teilen im Verhältnis von g zu $cm^3$.

Beispiele 1 bis 100 und Vergleichsbeispiele V1 bis V16

Eine elektrochemisch in Säure aufgerauhte und anodisch oxidierte Aluminiumplatte (Oxidschichtgewicht von etwa 3 g/m2) wird mit einer wäßrigen Polyvinylphosphonsäurelösung hydrophilierend in einer Tauchstufe nachbehandelt und getrocknet. Auf das so vorbehandelte Trägermaterial wird eine positiv-arbeitende lichtempfindliche Beschichtung aus (siehe EP-OS 0 055 814):

1,82 Gew.-Teilen eines Naphthochinondiazidsulfonsäureesters eines Diazostickstoffgehalts von 4,7 %, hergestellt aus Naphthochinon-(1,2)-diazid-(2)-5-sulfonsäurechlorid, Kresol-Formaldehyd-Novolak und 2,3,4-Trihüdroxy-benzophenon in Gegenwart einer Base,

0,22 Gew.-Teilen Naphthochinon-(1,2)-diazid-(2)-4-sulfonsäurechlorid,

0,07 Gew.-Teilen eines Kresol-Formaldehyd-Novolaks mit einem Schmelzbreich von 105 bis 120°C (nach DIN 53 181), und

0,08 Gew.-Teilen Kristallviolett, in

91,19 Gew.-Teilen eines Gemisches aus 5 Vol.-Teilen Tetrahydrofuran, 4 Vol.-Teilen Ethylenglykolmonomethylether und 1 Vol.- Teil Essigsäure-butylester

4

aufgebracht, die nach dem Trocknen ein Schichtgewicht von 2,3 g/m$^2$ aufweist. Das so hergestellte Kopiermaterial wird unter einer gerasterten Positivvorlage bildmäßig während 1 min belichtet und anschließend mit einer der in der Tabelle angegebenen Entwicklerlösungen entwickelt. Die Entwicklungszeiten betragen 2 bzw. 10 min, wobei in allen Fällen nach 2 min praktisch noch kein Oxidschichtangriff stattfindet. Der Vergleich von erfindungsgemäß zusammengesetzten Entwicklerlösungen mit solchen, bei denen eine der Komponenten Silikat oder quaternäre Ammoniumbase weggelassen wurde, zeigt deutlich den erfindungsgemaßen Fortschritt, d. h. eine steilere Gradation in den Bildstellen und auch eine positive Beeinflussung des Oxidschichtangriffs (d. h. Verringerung). Wenn in erfindungsgemäßen Entwicklerlösungen der Benzoat-Zusatz weggelassen oder verringert wird, so tritt keine signifikante Änderung in den Meßwerten bezüglich der Gradation und des Auflösevermögens auf, eine gewisse Beeinflussung in Richtung auf einen geringeren Oxidschichtangriff ist jedoch bei Benzoat-Zusatz zu beobachten. In den Vergleichsbeispielen V6 bis V15 wurde als quaternäre Ammoniumbase sowohl TEAH als auch TBMAH eingesetzt.

Als Maß für die Steilheit der Gradation wird die Differenz aus der ersten voll-gedeckten Keilstufe und der letzten nicht-gedeckten Keilstufe auf einem Belichtungstestkeil mit 13 Stufen und einer Keilkonstante von 0,15 (Dichte der ersten Stufe beträgt 0,15, die der letzten 1,95; beispielsweise Kalle Belichtungstestkeil BK 01, vertrieben von Kalle, Niederlassung der Hoechst AG) ermittelt. Je geringer die Differenz ist, desto steiler ist die Gradation.

Das Auflösevermögen wird mit dem sogenannten "K-Feld" des Fogra-Präzisionsmeßstreifens "PMS-K" bestimmt [siehe "fogra praxis report" - Nr. 24, "Die FOGRA-Präzisions-Meßstreifen", herausgegeben von der Deutschen Forschungsgesellschaft für Druck- und Reproduktionstechniken e. V. (FOGRA), Januar 1979 - München]. Das "K-Feld" enthält 9 Teilfelder mit Spalten und Strichen in 9 verschiedenen Breiten von 4 bis 40 μm. Jedes Teilfeld ist durch eine Ziffer gekennzeichnet, welche die Strich- bzw. Spaltenbreite in μm angibt. Der sogenannte "K-Wert" (siehe Tabelle) mit Werten von 4 bis 40 bezeichnet jeweils das feinste gerade noch wiedergegebene Strichfeld. Beträgt der "K-Wert" beispielsweise 4, d. h. das Auflösevermögen 4 μm, so können 4 μm breite Striche und Spalten in einer Kopie gerade noch getrennt wiedergegeben werden.

In den Beispielen wurde als Silikat immer ein $Na_2SiO_3 \cdot 9H_2O$ und als Benzoat ein Na-benzoat eingesetzt.

**Tabelle**

| Bei- spiel Nr. | Gehalt der wäßrig-alkalischen Entwicklerlösung in Gew.-% an | | | Entwicklungsgeschwindigkeit | | | |
| | | | | nach 2 min | nach 10 min | | |
| | Silikat | Benzoat | quaternärer Ammoniumbase | Steilheit der Gradation | Steilheit der Gradation | Auflöse- vermögen | Oxidschicht- angriff |
|---|---|---|---|---|---|---|---|
| V 1 | 5,3$\alpha$) | - | - | 7,0 | 8,0 | 4 | kein |
| V 2 | 6,0 | 1,0 | - | 7,0 | 7,5 | 6 | kein |
| V 3 | 8,0 | 1,0 | - | 6,5 | 8,5 | 8 | kein |
| V 4 | 10,0 | 1,0 | - | 10,0 | -$\gamma$) | 12 | stark |
| V 5 | 12,0 | 1,0 | - | 10,0 | -$\gamma$) | 12 | stark |
| V 6 | - | - | 0,01 | -$\delta$) | - | - | - |
| V 7 | - | - | 0,10 | - | - | - | - |
| V 8 | - | - | 1,00 | - | - | - | - |
| V 9 | - | - | 5,00 | - | - | - | - |
| V 10 | - | - | 10,00 | - | - | - | - |
| V 11 | - | 1,0 | 0,01 | - | - | - | - |
| V 12 | - | 1,0 | 0,10 | - | - | - | - |
| V 13 | - | 1,0 | 1,00 | - | - | - | - |
| V 14 | - | 1,0 | 5,00 | - | - | - | - |
| V 15 | - | 1,0 | 10,00 | - | - | - | - |
| V 16 | 7,2$\beta$) | - | - | 7,0 | 6,0 | 6 | kein |

**Tabelle** Fortsetzung I)

| Bei-spiel Nr. | Gehalt der wäßrig-alkalischen Entwicklerlösung in Gew.-% an | | | | nach 2 min | Entwicklungsgeschwindigkeit | nach 10 min | |
|---|---|---|---|---|---|---|---|---|
| | Silikat | Benzoat | quaternärer Ammoniumbase·) | | Steilheit der Gradation | Steilheit der Gradation | Auflöse-vermögen | Oxidschicht-angriff |
| 1 | 6,0 | 1,0 | TMAH | 0,01 | 4,0 | 6,0 | 4 | kein |
| 2 | 6,0 | 1,0 | " | 0,02 | 5,0 | 6,0 | 4 | " |
| 3 | 6,0 | 1,0 | " | 0,04 | +) | 6,0 | 4 | " |
| 4 | 6,0 | 1,0 | " | 0,08 | +) | +) | 4 | " |
| 5 | 6,0 | 1,0 | " | 0,10 | +) | +) | 4 | " |
| 6 | 6,0 | 1,0 | " | 0,01 | 3,0 | 5,0 | 4 | " |
| 7 | 6,0 | 1,0 | " | 0,02 | +) | 4,0 | 4 | " |
| 8 | 6,0 | 1,0 | " | 0,04 | +) | +) | 4 | " |
| 9 | 6,0 | 1,0 | " | 0,08 | +) | +) | +) | " |
| 10 | 6,0 | 1,0 | " | 0,10 | +) | +) | +) | " |
| 11 | 6,0 | 1,0 | TPAH | 0,01 | 3,5 | 4,0 | 4 | kein |
| 12 | 6,0 | 1,0 | " | 0,02 | 3,0 | 3,0 | 4 | " |
| 13 | 6,0 | 1,0 | " | 0,04 | 3,0 | 5,0 | 4 | " |
| 14 | 6,0 | 1,0 | " | 0,08 | +) | +) | 4 | " |
| 15 | 6,0 | 1,0 | " | 0,10 | +) | +) | 4 | " |
| 16 | 6,0 | 1,0 | TBAH | 0,01 | 4,0 | 5,5 | 4 | " |
| 17 | 6,0 | 1,0 | " | 0,02 | 3,0 | 4,0 | 4 | " |
| 18 | 6,0 | 1,0 | " | 0,04 | 3,0 | 3,5 | 4 | " |
| 19 | 6,0 | 1,0 | " | 0,08 | 3,0 | 5,0 | 4 | " |
| 20 | 6,0 | 1,0 | " | 0,10 | +) | +) | 4 | " |
| 21 | 6,0 | 1,0 | TBMAH | 0,01 | 3,0 | 4,0 | 4 | kein |
| 22 | 6,0 | 1,0 | " | 0,02 | 4,0 | 4,0 | 4 | " |
| 23 | 6,0 | 1,0 | " | 0,04 | +) | +) | 4 | " |
| 24 | 6,0 | 1,0 | " | 0,08 | +) | +) | 4 | " |
| 25 | 6,0 | 1,0 | " | 0,10 | +) | +) | 4 | " |
| 26 | 8,0 | 1,0 | TMAH | 0,01 | 5,0 | 5,0 | 6 | " |
| 27 | 8,0 | 1,0 | " | 0,02 | 5,0 | 5,0 | 6 | " |
| 28 | 8,0 | 1,0 | " | 0,04 | 4,5 | 5,0 | 4 | " |
| 29 | 8,0 | 1,0 | " | 0,08 | 5,0 | 4,5 | 4 | " |
| 30 | 8,0 | 1,0 | " | 0,10 | 4,5 | 5,0 | 4 | " |
| 31 | 8,0 | 1,0 | TEAH | 0,01 | +) | 5,0 | 4 | kein |
| 32 | 8,0 | 1,0 | " | 0,02 | 2,0 | +) | 4 | " |
| 33 | 8,0 | 1,0 | " | 0,04 | 2,0 | 2,5 | 4 | " |
| 34 | 8,0 | 1,0 | " | 0,08 | 1,5 | 2,5 | 6 | " |
| 35 | 8,0 | 1,0 | " | 0,10 | 3,0 | 5,0 | 6 | " |
| 36 | 8,0 | 1,0 | TPAH | 0,01 | 3,5 | 4,0 | 6 | " |
| 37 | 8,0 | 1,0 | " | 0,02 | 2,0 | 6,0 | 6 | " |
| 38 | 8,0 | 1,0 | " | 0,04 | 3,0 | 3,0 | 6 | " |
| 339 | 8,0 | 1,0 | " | 0,08 | 3,0 | 5,0 | 4 | " |
| 40 | 8,0 | 1,0 | " | 0,10 | 3,5 | 6,5 | 4 | " |
| 41 | 8,0 | 1,0 | TBAH | 0,01 | 4,5 | 3,5 | 8 | kein |
| 42 | 8,0 | 1,0 | " | 0,02 | 4,0 | 3,0 | 8 | " |
| 43 | 8,0 | 1,0 | " | 0,04 | 3,0 | 2,5 | 6 | " |
| 44 | 8,0 | 1,0 | " | 0,08 | 3,5 | 4,5 | 6 | " |
| 45 | 8,0 | 1,0 | " | 0,10 | 3,0 | 4,5 | 6 | " |
| 46 | 8,0 | 1,0 | TBMAH | 0,01 | 3,0 | 3,0 | 6 | " |
| 47 | 8,0 | 1,0 | " | 0,02 | 2,5 | 3,0 | 6 | " |
| 48 | 8,0 | 1,0 | " | 0,04 | 3,0 | 5,0 | 4 | " |
| 49 | 8,0 | 1,0 | " | 0,08 | 3,5 | 5,0 | 4 | " |
| 50 | 8,0 | 1,0 | " | 0,10 | 4,0 | 5,5 | 4 | " |

**Tabelle** (Fortsetzung)

| Bei-spiel Nr. | Gehalt der wäßrig-alkalischen Entwicklerlösung in Gew.-% an | | | Entwicklungsgeschwindigkeit | | | |
|---|---|---|---|---|---|---|---|
| | Silikat | Benzoat | quaternärer Ammoniumbase[)] | nach 2 min Steilheit der Gradation | nach 10 min Steilheit der Gradation | Auflöse-vermögen | Oxidsicht-angriff |
| 51 | 10,0 | 1,0 | TMAH 0,01 | 5,0 | 6,0 | 6 | leicht |
| 52 | 10,0 | 1,0 | " 0,02 | 5,5 | 7,0 | 4 | " |
| 53 | 10,0 | 1,0 | " 0,04 | 5,0 | 5,0 | 4 | " |
| 54 | 10,0 | 1,0 | " 0,08 | 5,0 | 5,0 | 4 | " |
| 55 | 10,0 | 1,0 | " 0,10 | 4,0 | 4,5 | 4 | " |
| 56 | 10,0 | 1,0 | TEAH 0,01 | 3,0 | 4,0 | 6 | " |
| 57 | 10,0 | 1,0 | " 0,02 | 2,0 | 2,5 | 6 | " |
| 58 | 10,0 | 1,0 | " 0,04 | 2,5 | 2,5 | 6 | " |
| 59 | 10,0 | 1,0 | " 0,08 | 2,0 | 3,5 | 4 | " |
| 60 | 10,0 | 1,0 | " 0,10 | 4,5 | 5,0 | 4 | " |
| 61 | 10,0 | 1,0 | TPAH 0,01 | 3,5 | 4,0 | 8 | leicht |
| 62 | 10,0 | 1,0 | " 0,02 | 3,5 | 5,0 | 8 | " |
| 63 | 10,0 | 1,0 | " 0,04 | 2,5 | 3,5 | 6 | " |
| 64 | 10,0 | 1,0 | " 0,08 | 3,0 | 3,5 | 6 | " |
| 65 | 10,0 | 1,0 | " 0,08 | 3,0 | 3,5 | 6 | " |
| 66 | 10,0 | 1,0 | TBAH 0,01 | 4,0 | 5,5 | 10 | " |
| 67 | 10,0 | 1,0 | " 0,02 | 3,5 | 4,0 | 8 | " |
| 68 | 10,0 | 1,0 | " 0,04 | 4,0 | 4,5 | 6 | " |
| 69 | 10,0 | 1,0 | " 0,08 | 4,0 | 5,0 | 6 | " |
| 70 | 10,0 | 1,0 | " 0,10 | 4,0 | 5,0 | 6 | " |
| 71 | 10,0 | 1,0 | TBMAH 0,01 | 2,5 | 3,0 | 6 | leicht |
| 72 | 10,0 | 1,0 | " 0,02 | 3,0 | 3,0 | 6 | " |
| 73 | 10,0 | 1,0 | " 0,04 | 3,0 | 4,0 | 6 | " |
| 74 | 10,0 | 1,0 | " 0,08 | 2,5 | 4,0 | 6 | " |
| 75 | 10,0 | 1,0 | " 0,10 | 3,0 | 5,0 | 4 | " |
| 76 | 12,0 | 1,0 | TMAH 0,01 | 8,0 | 11,0 | 6 | stark |
| 77 | 12,0 | 1,0 | " 0,02 | 9,0 | 10,0 | 6 | " |
| 78 | 12,0 | 1,0 | " 0,04 | 7,0 | 8,5 | 6 | " |
| 79 | 12,0 | 1,0 | " 0,08 | 6,0 | 7,5 | 6 | " |
| 80 | 12,0 | 1,0 | " 0,01 | 4,0 | 6,0 | 6 | " |
| 81 | 12,0 | 1,0 | TEAH 0,01 | 6,0 | 6,0 | 4 | stark |
| 82 | 12,0 | 1,0 | " 0,02 | 3,5 | 6,0 | 8 | " |
| 83 | 12,0 | 1,0 | " 0,04 | 1,5 | 2,0 | 6 | " |
| 84 | 12,0 | 1,0 | " 0,08 | 1,0 | 2,5 | 4 | " |
| 85 | 12,0 | 1,0 | " 0,10 | 3,0 | 6,0 | 6 | " |
| 86 | 12,0 | 1,0 | TPAH 0,01 | 3,5 | 5,0 | 10 | " |
| 87 | 12,0 | 1,0 | " 0,02 | 2,5 | 7,0 | 6 | " |
| 88 | 12,0 | 1,0 | " 0,04 | 2,0 | 3,0 | 8 | leicht |
| 89 | 12,0 | 1,0 | " 0,08 | 2,0 | 4,0 | 6 | stark |
| 90 | 12,0 | 1,0 | " 0,10 | 2,5 | 5,0 | 6 | " |
| 91 | 12,0 | 1,0 | TBAH 0,01 | 5,0 | 7,0 | 10 | leicht |
| 92 | 12,0 | 1,0 | " 0,02 | 4,0 | 6,0 | 10 | " |
| 93 | 12,0 | 1,0 | " 0,04 | 3,0 | 4,0 | 8 | stark |
| 94 | 12,0 | 1,0 | " 0,08 | 3,0 | 5,0 | 8 | " |
| 95 | 12,0 | 1,0 | " 0,10 | 4,0 | 6,0 | 6 | " |
| 96 | 12,0 | 1,0 | TBMAH 0,01 | 4,0 | 6,0 | 8 | stark |
| 97 | 12,0 | 1,0 | " 0,02 | 3,0 | 4,0 | 8 | " |
| 98 | 12,0 | 1,0 | " 0,04 | 3,0 | 4,0 | 8 | " |
| 99 | 12,0 | 1,0 | " 0,08 | 3,0 | 6,0 | 8 | " |
| 100 | 12,0 | 1,0 | " 0,10 | 3,0 | 5,5 | 6 | " |

$\alpha$) weitere Bestandteile sind 3,4 Gew.-% $Na_3PO_4 \cdot 12H_2O$ und 0,3 Gew.-% $NaH_2PO_4$
$\beta$) weitere Bestandteile sind 0,02 Gew.-% $Sr^{3+}$-Ionen und 0,03 Gew.-% Lävulinsäure
$\gamma$) eine voll gedeckte Keilstufe ist bei der vorgegebenen Belichtungszeit nicht mehr zu ermitteln
$\delta$) eine Aufentwicklung (d. h. Differenzierung in Bild- und Nichtbildstellen) findet nicht statt
+) In den Nichtbildstellen tritt "Ton" auf

**0 131 575**

-) Prozentangaben beziehen sich immer auf eine 20 %ige wäßrige Lösung, d. h. 0,01 % bedeutet tatsächlich 0,002 % Wirkstoff

**Patentansprüche**

1. Wäßrig-alkalische Entwicklerlösung für strahlungsempfindliche, positiv-arbeitende Reproduktionsschichten auf der Basis von Silikaten und einem Hydroxid, dadurch gekennzeichnet, daß sie 0,001 bis 1,0 Gewichtsprozent an Tetraalkylammoniumhydroxid, dessen Alkylsubstituenten gleich oder verschieden sind und 1 bis 6 C-Atome enthalten, oder ein Salz davon und 5 bis 15 Gewichtsprozent an Alkalisilikat enthält.

2. Entwicklerlösung nach Anspruch 1, dadurch gekennzeichnet, daß sie zusätzlich ein Salz einer organischen, gegebenenfalls substituierten aromatischen Monocarbonsäure enthält.

3. Entwicklerlösung nach Anspruch 2, dadurch gekennzeichnet, daß sie ein Salz der gegebenenfalls substituierten Benzoesäure enthält.

4. Entwicklerlösung nach einem der Ansprüche 2 oder 3, dadurch gekennzeichnet, daß sie 0,01 bis 10,0 Gew.-% des Salzes enthält.

5. Verfahren zum Entwickeln von belichteten, strahlungsempfindlichen, positiv-arbeitenden Reproduktionsschichten auf einem Trägermaterial auf der Basis von Aluminium, bei dem die belichteten Schichtbereiche mit einer wäßrig-alkalischen Entwicklerlösung ausgewaschen werden, die Silikate und ein Hydroxid enthält, dadurch gekennzeichnet, daß man eine Entwicklerlösung einsetzt, die 0,001 bis 1,0 Gewichtsprozent an Tetraalkylammoniumhydroxid, dessen Alkylsubstituenten gleich oder verschieden sind und 1 bis 6 C-Atome ent halten, oder ein Salz davon und 5 bis 15 Gewichtsprozent an Alkalisilikat enthält.

6. Verfahren nach Anspruch 5, dadurch gekennzeichnet, daß die Entwicklerlösung zusätzlich ein Salz einer organischen, gegebenenfalls substituierten, aromatischen Monocarbonsäure enthält.

7. Verfahren nach einem der Ansprüche 5 oder 6, dadurch gekennzeichnet, daß die Reproduktionsschicht ein o-Naphthochinondiazid als strahlungsempfindliche Verbindung und ein alkalilösliches Harz enthält.

8. Verfahren nach einem der Ansprüche 5 bis 7, dadurch gekennzeichnet, daß das Trägermaterial mindestens eine anodisch erzeugte Aluminiumoxidschicht aufweist.

**Claims**

1. Aqueous-alkaline developer solution for radiation-sensitive, positive-working reproduction layers, based on silicates and a hydroxide, wherein 0.001 to 1.0 percent by weight of a tetraalkylammonium hydroxide, the alkyl substituents of which are identical or different and possess 1 to 6 carbon atoms, or a salt thereof, and 5 to 15 percent by weight of an alkali metal silicate are contained.

2. Developer solution as claimed in Claim 1, wherein a salt of an organic, optionally substituted, aromatic monocarboxylic acid is additionally contained.

3. Developer solution as claimed in Claim 2, wherein a salt of optionally substituted benzoic acid is contained.

4. Developer solution as claimed in any of Claims 2 or 3, wherein 0.01 to 10.0 percent by weight of the salt are contained.

5. Process for developing exposed, radiation-sensitive, positive-working reproduction layers on a support material based on aluminum, in which the exposed areas of the layer are washed out with an aqueous-alkaline developer solution comprised of silicates and a hydroxide, wherein the developer solution employed contains 0.001 to 1.0 percent by weight of a tetraalkylammonium hydroxide, the alkyl substituents of which are identical or different and possess 1 to 6 carbon atoms, or a salt thereof, and 5 to 15 percent by weight of an alkali metal silicate.

6. Process as claimed in Claim 5, wherein the developer solution additionally contains a salt of an organic, optionally substituted, aromatic monocarboxylic acid.

7. Process as claimed in Claim 5 or 6, wherein the reproduction layer comprises an o-naphthoquinone diazide as radiation-sensitive compound and an alkali-soluble resin.

8. Process as claimed in any of Claims 5 to 7, wherein the support material comprises at least one aluminum oxide layer produced by anodic oxidation.

**Revendications**

1. Solution de développement aqueuse alcaline à base de silicates et d'un hydroxyde, pour couches de reproduction sensibles à l'irradiation travaillant en positif, caractérisée en ce qu'elle contient de 0,001 à 1,0 % en poids d'un hydroxyde de tétra-alkylammonium dont les substituants alkyle sont identiques ou différents et contiennent de 1 à 6 atomes de carbone, ou d'un sel de celui-ci, et de 5 à 15 % en poids d'un silicate alcalin.

2. Solution de développement selon la revendication 1, caractérisée en ce qu'elle contient en outre un sel d'un acide monocarboxylique organique, aromatique, éventuellement substitué.

3. Solution de développement selon la revendication 2, caractérisée en ce qu'elle contient un sel de l'acide benzoïque éventuellement substitué.

4. Solution de développement selon l'une des revendications 2 ou 3, caractérisée en ce qu'elle contient de 0,01 à 10,0 % en poids du sel.

5. Procédé pour le développement de couches de reproduction sensibles à l'irradiation, travaillant en positif, exposées, sur un matériau de support à base d'aluminium, dans lequel procédé les zones exposées de la couche sont éliminées par lavage avec une solution de développement aqueuse alcaline qui contient des silicates et un hydroxyde, caractérisé en ce que l'on utilise une solution de développement qui contient de 0,001 à 1,0 % en poids d'un hydroxyde de tétra-alkylammonium, dont les substituants alkyle sont identiques ou différents et contiennent de 1 à 6 atomes de carbone, ou d'un sel de celui-ci, et de 5 à 15 % en poids d'un silicate alcalin.

6. Procédé selon la revendication 5, caractérisé en ce que la solution de développement contient en outre un sel d'un acide carboxylique organique, aromatique, éventuellement substitué.

7. Procédé selon l'une des revendications 5 ou 6, caractérisé en ce que la couche de reproduction contient un o-naphtoquinone-diazide en tant que composé sensible à l'irradiation et une résine soluble dans des alcalis.

8. Procédé selon l'une des revendications 5 à 7, caractérisé en ce que le matériau de support présente au moins une couche d'oxyde d'aluminium obtenue par voie anodique.